# EUROPEAN PATENT SPECIFICATION

(11) **EP 2 612 952 B1**
(45) Date of publication and mention of the grant of the patent: **12.11.2014**
(21) Application number: 11821373.5
(22) Date of filing: 12.05.2011
(51) Int. Cl.: C23C 14/34, B22D 7/00, B22D 21/02, B22D 31/00, B23D 79/00

(54) **INDIUM TARGET AND METHOD FOR PRODUCING SAME**
INDIUMTARGET UND HERSTELLUNGSVERFAHREN DAFÜR
CIBLE D'INDIUM ET SON PROCÉDÉ DE PRODUCTION

(30) Priority: 31.08.2010 JP 2010194532
(43) Date of publication of application: 10.07.2013
(73) Proprietor: JX Nippon Mining & Metals Corporation, Tokyo 100-8164 (JP)
(72) Inventor: MAEKAWA, Takamasa, Kitaibaraki-shi Ibaraki 319-1535 (JP); ENDO, Yousuke, Kitaibaraki-shi Ibaraki 319-1535 (JP)
(74) Representative: Yeadon, Mark
(86) International application number: PCT/JP2011/060969
(87) International publication number: WO 2012/029355

(56) References cited:
- JP-A- 8 281 208
- JP-A- 2003 089 869
- JP-A- 2005 002 364
- JP-A- 2010 024 474

## Description

### BACKGROUND OF THE INVENTION

### 1. Field of the Invention

The present invention relates to a sputtering target and a method for producing the sputtering target, and particularly, to an indium target and a method for producing the indium target.

### 2. Description of Related Art

Indium is used as a sputtering target for the formation of a photoabsorption layer of a Cu-In-Ga-Se type (CIGS type) thin-film solar cell.

Conventionally, an indium target is manufactured by fluid casting of indium into a mold after bonding an indium alloy or the like on a backing plate as disclosed in Japanese Patent Application Publication No. JPS 57-185973 A.

JP 2010-024474 A discloses a method for producing an indium target in which less indium oxide enters an inner layer of the hot metal, which is particularly useful for forming a light-absorbing indium film formed of a stacked Cu-Ga/In precursor for a thin-film solar cell.

### SUMMARY OF THE INVENTION

However, in the case of producing an indium target by such a melt casting method as in JPS 57-185973 A, an indium ingot obtained by flow casting of indium into a mold allows the formation of an oxide film on the surface thereof if it has not been surface-treated. If the surface of the ingot is abraded to remove this oxide film, the surface is roughened on the contrary because indium is a very soft metal. Such a roughened surface of an indium target is a cause of generation of arcing during sputtering.

In view of this situation, it is an object of the present invention to provide an indium target capable of satisfactorily restraining the generation of arcing and a method for producing the indium target.

The inventors of the present invention have made earnest studies to solve the above problem, and as a result, found that the generation of arcing can be satisfactorily restrained when the arithmetic average roughness (Ra) of the target surface is designed to be 1.6 µm or less, and preferably, further the ten-point height of irregularities (Rz) of the target surface is designed to be 15 µm or less by subjecting the surface of the indium target manufactured by the melt casting method to cutting processing.

According to a first aspect of the present invention completed based on the above teachings, there is provided an indium target having a surface arithmetic average roughness (Ra) of 1.6 µm or less.

In an embodiment of the indium target according to the present invention, the arithmetic average roughness (Ra) is 1.2 µm or less.

In another embodiment of the indium target according to the present invention, the ten-point height of irregularities (Rz) of the surface of the target is 15 µm or less.

In still another embodiment of the indium target according to the present invention, the ten-point height of irregularities (Rz) is 10 µm or less.

According to another aspect of the present invention, there is provided a method for producing an indium target, the method comprising melt-casting an indium raw material and then, by subjecting the cast material to cutting processing using a scraper to produce an indium target.

According to the present invention, an indium target capable of satisfactorily restraining the generation of arcing and a method for producing the indium target.

### DETAILED DESCRIPTION OF EMBODIMENTS

An indium target according to the present invention is characterized by the feature that the arithmetic average roughness (Ra) of the surface of the target is 1.6 µm or less. When the arithmetic average roughness (Ra) of the surface of the target exceeds 1.6 µm, there is a fear as to the generation of arcing when the target is treated by sputtering. The arithmetic average roughness (Ra) of the surface of the target is preferably 1.2 µm or less and more preferably 1.0 µm or less. The "arithmetic average roughness (Ra)" in the present invention is based on the definition according to JIS B0601-1994.

An indium target according to the present invention is characterized by the feature that the ten-point height of irregularities (Rz) of the surface of the target is 15 µm or less. When the ten-point height of irregularities (Rz) of the surface of the target is 15 µm or less, the generation of arcing when the target is treated by sputtering can be more satisfactorily restrained. The ten-point height of irregularities (Rz) of the surface of the target is preferably 10 µm or less and more preferably 8 µm or less. The "ten-point height of irregularities (Rz)" in the present invention is based on the definition according to JIS B0601-1994.

Next, preferable examples of the method for producing an indium target according to the present invention will be explained one after another. First, indium which is a raw material is melted and cast into a mold. The raw material indium to be used preferably has high purity from the reason that if impurities are contained in the raw material, the conversion efficiency of a solar cell to be produced from the raw material is deteriorated. For example, indium having a purity of 99.99% by mass or more may be used. After that, the molten raw material is cooled to ambient temperature to form an indium ingot. As to the cooling speed in this case, the molten raw material may be allowed to cool naturally.

In succession, the obtained indium ingot is subjected to cold rolling to reduce the ingot to a desired thickness according to the need, and is further subjected to washing with acids and defatting according to the need. Next, the surface of the ingot is subjected to cutting processing using a scraper having a blade width of 5 to 100 mm, for example, to thereby produce an indium target. No particular limitation is imposed on the scraper insofar as it has a hardness enough to stand against the cutting of the surface of the indium target and is superior in wear resistance. For example, scrapers made of metals such as stainless steel or high chrome steel, or, if possible, ceramics scrapers may also be used. When the surface of the target is abraded by such a scraper, the target is processed such that the arithmetic average roughness (Ra) of the surface of the target is designed to be 1.6 µm or less, preferably 1.2 µm or less, and more preferably 1.0 µm or less. Also, the target is processed such that the ten-point height of irregularities (Rz) of the surface of the target is designed to be 15 µm or less, preferably 10 µm or less, and more preferably 8 µm or less.

The indium target obtained in this manner can be preferably used as a sputtering target for a CIGS type thin film solar cell photoabsorption layer.

### EXAMPLES

The present invention will be explained below by way of Examples and Comparative Examples. These examples are provided to understand the present invention and its advantage, but are not intended to limit the present invention.

### (Example 1)

The periphery of a copper bucking plate having a diameter of 250 mm and a thickness of 5 mm was enclosed by a cylindrical mold 205 mm in diameter and 7 mm in height and an indium raw material which had been melted at 160°C was cast into the inside of the mold. The cast indium raw material (purity: 5N) was cooled to ambient temperature to form a disk-like indium got (204 mm (diameter) × 6 mm (thickness)). In succession, the surface of the indium got was subjected to cutting processing by a stainless scraper having a blade width of 20 mm to obtain an indium target.

### (Example 2)

An indium target was manufactured under the same conditions as in Example 1 except that the blade width of the stainless scraper was 40 mm.

### (Example 3)

An indium target was manufactured under the same conditions as in Example 1 except that the blade width of the stainless scraper was 10 mm.

### (Example 4)

An indium target was manufactured under the same conditions as in Example 1 except that the blade width of the stainless scraper was 5 mm.

### (Comparative Example 1)

An indium target was manufactured under the same conditions as in Example 1 except that the surface of the target was not cut.

### (Comparative Example 2)

An indium target was manufactured under the same conditions as in Example 1 except that milling was performed instead of performing the cutting processing of the surface of the target by using a stainless scraper.

### (Evaluation)

With regard to each indium target obtained in Examples and Comparative Examples, "Arithmetic average roughness (Ra)" and "Ten-point height of irregularities (Rz)" prescribed in JIS B0601-1994 were measured.

Further, each indium target obtained in Examples and Comparative Examples was put in a sputtering system (trademark: SPF-313H, manufactured by CANON ANERVA CORPORATION) to carry out sputtering in the following condition: ultimate vacuum pressure in the chamber before the sputtering was started: 1 × 10⁻⁴ Pa, sputtering pressure: 0.5 Pa, flow rate of argon sputtering gas: 5 SCCM, sputtering power: 650 W, sputtering time: 30 min, thereby visually measuring the number of arcing during sputtering.

Each measuring result is shown in Table 1.

**[Table 1]**

| | Ra(µm) | Rz(µm) | number of arcing |
|---|---|---|---|
| Example 1 | 1.3 | 12 | 0 |
| Example 2 | 1.6 | 15 | 0 |
| Example 3 | 1.2 | 10 | 0 |
| Example 4 | 0.8 | 8 | 0 |
| Comparative Example 1 | 2 | 20 | 80 |
| Comparative Example 2 | 50 | 150 | 250 |

In Example 1, the surface of the target was subjected to cutting processing by a stainless scraper having a blade width of 20 mm, and therefore the arithmetic average roughness (Ra) was 1.3 µm and the ten-point height of irregularities (Rz) was 12 µm. Therefore, arcing was not confirmed.

In Example 2, the surface of the target was subjected to cutting processing by a stainless scraper having a blade width as large as 40 mm as compared with that of Example 1, so that the arithmetic average roughness (Ra) was 1.6 µm and the ten-point height of irregularities (Rz) was 15 µm. Therefore, the surface was more roughened than that in Example 1. However, arcing was not confirmed.

In Example 3, the surface of the target was subjected to cutting processing by a stainless scraper having a blade width as small as 10 mm as compared with that of Example 1, so that the arithmetic average roughness (Ra) was 1.2 µm and the ten-point height of irregularities (Rz) was 10 µm. Therefore, the surface was flatter than that in Example 1 and arcing was not confirmed.

In Example 4, the surface of the target was subjected to cutting processing by a stainless scraper having a blade width as small as 5 mm as compared with that of Examples 1 and 3, so that the arithmetic average roughness (Ra) was 0.8 µm and the ten-point height of irregularities (Rz) was 8 µm. Therefore, the surface was smoother those in Examples 1 and 3, and arcing was not confirmed.

In Comparative Example 1, the surface of the target was not cut, so that the arithmetic average roughness (Ra) was 2 µm and the ten-point height of irregularities (Rz) was 20 µm, showing that the surface was rough and therefore, the number of arcing was as large as 80.

In Comparative Example 2, the surface of the target was surface-treated by milling instead of cutting processing using a scraper, so that the arithmetic average roughness (Ra) was 50 µm and the ten-point height of irregularities (Rz) was 150 µm, showing that the surface was rough and therefore, the number of arcing was as large as 250.

## Claims

1. An indium target having a surface arithmetic average roughness (Ra) of 1.6 µm or less and having a surface ten-point height of irregularities (Rz) of 15 µm or less.

2. The indium target according to Claim 1, the target having a surface arithmetic average roughness (Ra) of 1.2 µm or less.

3. The indium target according to Claim 1 or claim 2, the target having a surface ten-point height of irregularities (Rz) of 10 µm or less.

4. A method for producing an indium target, the method comprising:
melt-casting an indium target; and
performing cutting processing using a scraper to produce the indium target according to any of Claims 1 to 3.

## Patentansprüche

1. Indium-Target mit einem arithmetischen Mittenrauwert der Oberfläche (Ra) von 1,6 µm oder weniger und mit einer Zehnpunkthöhe der Profilunregelmäßigkeiten (Rz) von 15 µm oder weniger.

2. Indium-Target nach Anspruch 1, wobei das Target einen arithmetischen Mittenrauwert der Oberfläche (Ra) von 1,2 µm oder weniger aufweist.

3. Indium-Target nach Anspruch 1 oder Anspruch 2, wobei das Target eine Zehnpunkthöhe der Profilunregelmäßigkeiten (Rz) von 10 µm oder weniger aufweist.

4. Verfahren zum Herstellen eines Indium-Targets, umfassend:
Schmelzgießen eines Indium-Targets und
Durchführen von Schneidverarbeitung unter Verwendung eines Schabmessers,
um das Indium-Target nach einem der Ansprüche 1 bis 3 herzustellen.

## Revendications

1. Cible d'indium présentant une surface d'une rugosité arithmétique (Ra) moyenne de 1,6 µm ou moins et présentant une hauteur d'irrégularités (Rz) de dix points de 15 µm ou moins.

2. Cible d'indium selon la revendication 1, la cible présentant une surface d'une rugosité arithmétique (Ra) moyenne de 1,2 µm ou moins.

3. Cible d'indium selon la revendication 1 ou la revendication 2, la cible présentant une surface avec une hauteur d'irrégularités (Rz) de dix points de 10 µm ou moins.

4. Procédé de production d'une cible d'indium, le procédé comprenant :
la coulée par fusion d'une cible d'indium ; et
l'exécution d'un traitement de découpe à l'aide d'un couteau pour produire la cible d'indium selon l'une quelconque des revendications 1 à 3.
